(19) Europäisches Patentamt

European Patent Office

Office européen des brevets

(11) Veröffentlichungsnummer: **0 202 573**
**A2**

(12) **EUROPÄISCHE PATENTANMELDUNG**

(21) Anmeldenummer: **86106433.5**

(22) Anmeldetag: **12.05.86**

(51) Int. Cl.⁴: **H01L 27/08 , H01L 23/52**

(30) Priorität: **21.05.85 DE 3518264**

(43) Veröffentlichungstag der Anmeldung:
**26.11.86 Patentblatt 86/48**

(84) Benannte Vertragsstaaten:
**AT CH DE FR GB LI**

(71) Anmelder: **Siemens Aktiengesellschaft Berlin
und München
Wittelsbacherplatz 2
D-8000 München 2(DE)**

(72) Erfinder: **Duzy, Peter, Dipl.-Ing.
Passauer Strasse 54
D-8000 München 70(DE)**
Erfinder: **De Marino, Ralf, Dipl.-Ing.
Kafka-Strasse 16
D-8000 München 83(DE)**
Erfinder: **Schallenberger, Burghardt, Dr.
Brunnenweg 6a
D-8152 Feldolling(DE)**

(54) **In C-MOS-Technik realisierte Basiszelle und Verfahren zur automatischen Generierung einer derartigen Basiszelle.**

㉝ Eine C-MOS-Technik realisierte Basiszelle zum Aufbau von elektronischen Schaltkreisen, in der mehrere, maximal vier, Transistoren nebeneinander angeordnet sind, in der parallel zur Erstreckung der Transistoren erste, im wesentlichen aus Polysilizium bestehende Leiterbahnen angeordnet sind, in der senkrecht zu den ersten Leiterbahnen zweite, im wesentlichen aus Metall bestehende Leiterbahnen angeordnet sind und in der die zweiten Leiterbahnen entweder über die Transistoren oder zwischen den Transistoren verlaufen. Jeweils in einer von zwei Gruppen angeordnete Transistoren sind zu einer Parallel-oder Serienschaltung zusammengefaßt. In der Basiszelle sind Metallbahnen außerhalb der Transistorflächen am seitlichen Zellenrand angeordnet. Polysilizium-Leiterbahnen und/oder Metall-Leiterbahnen sind senkrecht zu den betreffenden Vorzugsrichtungen, nämlich parallel zur Erstreckung der Transistoren bzw. senkrecht dazu, ausgebildet. Die Leiterbahnen sind derart angeordnet, daß eine jeweils folgende Leiterbahn in ihrem Verlauf an die Kontur der zuvor festgelegten Leiterbahnen angepaßt ist. Außerdem sind erforderliche Kontakte an den Leiterbahnen derart in bezug auf die mit ihnen verbundenen Leiterbahnen verschoben angeordnet, daß sie in eine bei der betreffenden benachbarten Leiterbahn enthaltene Einbuchung hineinverschoben sind.

FIG 1

In C-MOS-Technik realisierte Basiszelle und Verfahren zur automatischen Generierung einer derartigen Basiszelle.

Die Erfindung bezieht sich auf eine in C-MOS-Technik realisierte Basiszelle zum Aufbau von elektrischen Schaltkreisen, wobei mehrere Transistoren nebeneinander angeordnet sind, wobei parallel zur Erstreckung der Transistoren erste, im wesentlichen aus Polysilizium bestehende Leiterbahnen angeordnet sind, wobei senkrecht zu den ersten Leiterbahnen zweite, im wesentlichen aus Metall bestehende Leiterbahnen angeordnet sind und wobei die zweiten Leiterbahnen entweder über die Transistoren oder zwischen den Transistoren verlaufen, sowie auf ein Verfahren zur automatischen Generierung einer derartigen Basiszelle nach Patentanmeldung P 34 22 715.6 DE.

Die steigende Komplexität von höchstintegrierten elektrischen Schaltkreisen macht den Handentwurf des Schaltungslayouts zunehmend schwieriger. Die große Anzahl der geometrischen Einzelstrukturen einer VLSI-Schaltung erzwingt den Übergang zur automatischen Layout-Generierung. Bei einem solchen Layout-Generierungsverfahren werden die geometrischen Layout-Strukturen mit Hilfe von Software aus einer abstrakten Schaltungsbeschreibung gewonnen. Dabei werden die einzelnen Layout-Rechtecke durch ein Programm dimensioniert und plaziert. Besondere Vorteile einer Layout-Erzeugung per Software sind hohe Flexibilität, schnelle Anpassung an neue Entwurfsregeln und kurze Entwurfszeiten.

Das Gesamtlayout einer elektronischen Schaltung wird aus einer Vielzahl von solchen Layout-Rechtecken gebildet. Beim personellen Entwurf der elektronischen Schaltung wird jedes Rechteck einzeln dimensioniert und individuell plaziert. Bei einem solchen Verfahren wird jedoch die Komplexität nicht reduziert, so daß Layouts von größeren Schaltungen nur mit großem Aufwand erzeugt werden können. Das Gate-Matrix-Verfahren hingegen reduziert die Komplexität des Schaltungsentwurfs, da für die Plazierung der geometrischen Strukturen nur bestimmte Rasterpunkte einer Matrix zugelassen werden. Nach dem Gate-Matrix-Prinzip werden Layouts im Umfang von Standardzellen erzeugt und anschließend mit herkömmlichen Methoden weiterverarbeitet. Ein anderes Verfahren zur automatischen Layout-Erzeugung auch von umfangreichen VLSI-Schaltungen reduziert die Komplexität des Schaltungsentwurfs mit Hilfe des Basiszellenkonzepts. Dabei wird ein Layout aus im hohen Maße parametrisierten Basiszellen aufgebaut. Innerhalb einer Basiszelle ist die relative Anordnung einzelner geometrischer Strukturen zueinander grob vorgegeben. Weitere Verfahren zur Herstellung von elektronischen Schaltkreisen können z.B. der Broschüre CAD für VLSI von H.G. Schwärtzel, Springer-Verlag, 1982, z.B. Seiten 63-76, entnommen werden.

Die der Erfindung zugrundeliegende Aufgabe besteht darin, in Weiterbildung der Patentanmeldung P 34 22 715.6 DE eine Basiszelle, die in C-MOS-Technik realisiert ist, anzugeben, die eine hohe Verdrahtungsflexibilität aufweist, die maximal vier Transistoren enthalten kann, welche zur Erzielung beliebiger geforderter digitaler Schaltkreise konfigurierbar sind, und deren Layout eine weiter verbesserte Flächennutzung gestattet. Ferner besteht die Aufgabe für die vorliegende weiterbildende Erfindung darin, ein Verfahren zur automatischen Generierung einer derartigen Basiszelle zu - schaffen.

Die Aufgabe zur Schaffung der angestrebten Basiszelle wird durch eine in C-MOS-Technik realisierte Basiszelle gemäß dem Oberbegriff des Patentanspruchs 1 gelöst, die durch die in dessen kennzeichnendem Teil angegebenen Merkmale charakterisiert ist.

Vorteilhafte Weiterbildungen der vorliegenden Erfindung sind durch die in den Unteransprüchen angegebenen Merkmale gekennzeichnet.

Die Aufgabe zur Schaffung eines Verfahrens zur automatischen Generierung einer derartigen Basiszelle wird durch die Merkmale des Patentanspruchs 5 gelöst.

Im folgenden wird die Erfindung anhand mehrerer Figuren, die jeweils Ausführungsbeispiele betreffen, im einzelnen beschrieben.

Fig.1 zeigt das Layout eines Ausführungsbeispiels für die erfindungsgemäße Basiszelle.

Fig.2 zeigt schematisch das Prinzip eines sog. Layering-Mechanismus.

Fig.3 zeigt das Layout eines typischen Funktionsblocks, der mit erfindungsgemäß generierten Basiszellen realisiert ist.

Fig.4 zeigt schematisch eine Struktur eines Basiszellen-Generatorprogramms.

Fig.5 zeigt schematisch ein Beispiel für eine sog. topologische Optimierung.

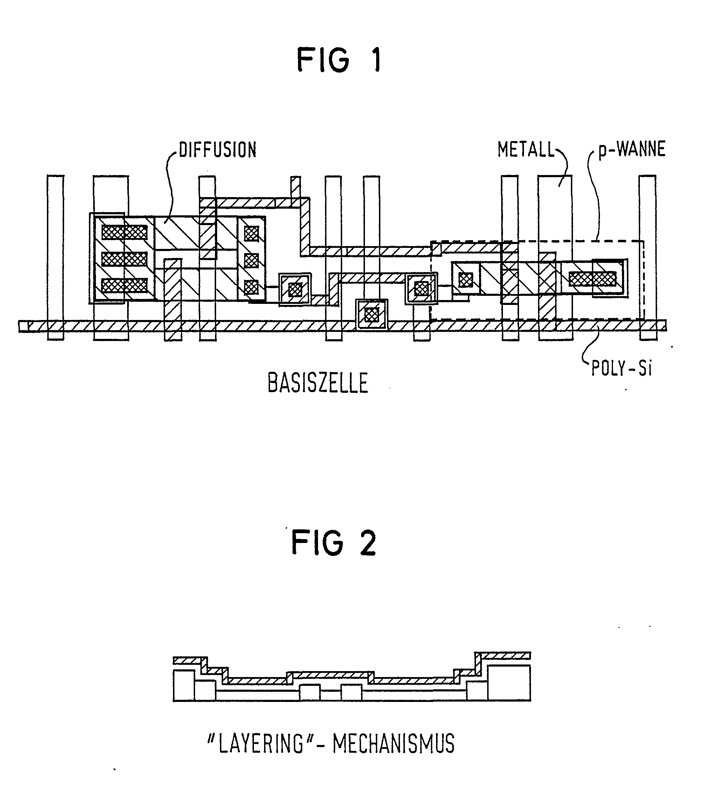

Basiszellen zum Aufbau eines Schaltungsmoduls umfassen nur wenige Transistoren. Fig.1 zeigt das Layout eines Ausführungsbeispiels für eine Basiszelle, das gemäß der vorliegenden Erfindung strukturiert ist. Diese in Fig.1 gezeigte Basiszelle ist beispielhaft als ein NAND-Glied mit zwei Eingängen ausgebildet.

Dieses Layout besteht aus zwei Transistorgebieten, die durch einen Verdrahtungskanal getrennt sind. Diese Anordnung zielt auf den Entwurf sog. Bit-Slice-Zellen eines Datenpfades in C-MOS-Technik ab. So liegen z.B. links des Verdrahtungskanals die p-Kanal-Transistoren, rechts die n-Kanal-Transistoren oder umgekehrt. Jedes Transistorgebiet kann aus einem Einzeltransistor oder einer Parallel- bzw. Serienschaltung zweier Transistoren bestehen. Alle Gates sind senkrecht angeordnet. Die vertikal geführten Metallbahnen sind für den Datenfluß und die Stromversorgung vorgesehen. Die Steuerleitungen in Polysilizium verlaufen horizontal. Um jedoch eine gute Flächenausnutzung zu erzielen, sind auch vertikale Polysilizium-Leitungen ausgebildet. Alle Transistoranschlüsse können an einem der vier Zellenränder an beliebiger Stelle sowohl in Metall als auch in Polysilizium herausgeführt werden. Die Anschlußbreiten sowie die internen Leiterbahnbreiten sind individuell vorgebbar. Durchläufer (Leitungen ohne zelleninternen Anschluß) lassen sich an beliebiger Stelle einfügen. Am linken und rechten Zellenrand ist jeweils ein Randbus vorgesehen, der die Koordinatenanpassung von horizontalen Leitungen an andere Schaltungen optimiert.

Trotz dieser vorgesehenen Entwurfsstrategie ist die Basiszelle nicht schaltungsspezifisch. Durch Besetzung einer Reihe von Parametern, die an ein Generatorprogramm zu übergeben sind, wird die Basiszelle individualisiert, d.h. es werden einer zu realisierenden Schaltung entsprechend Kontakte gesetzt, Verdrahtungsbahnen geführt und Transistoren dimensioniert. Sog. Expertenfunktionen optimieren die zelleninterne Layout-Ausführung.

Erfindungsgemäß sind maximal vier Transistoren je Basiszelle vorgesehen, wobei jeweils eine Gruppe von Transistoren in n-Kanaltechnik und eine andere Gruppe von Transistoren in p-Kanaltechnik ausgeführt sind, welche Gruppen jeweils einem ersten bzw. einem zweiten Bereich der Basiszelle zugeordnet sind. Die jeweils in einer der Gruppen angeordneten Transistoren sind zu einer Parallel-oder Serienschaltung zusammengefaßt. In der Basiszelle sind Metallbahnen außerhalb der Transistorflächen am seitlichen Zellenrand angeordnet. Polysilizium-Leiterbahnen und/oder Metall-Leiterbahnen sind senkrecht zu den betreffenden Vorzugsrichtungen, nämlich parallel zur Erstreckung der Transistoren bzw. senkrecht dazu, ausgebildet. Die Leiterbahnen sind derart angeordnet, daß eine jeweils folgende Leiterbahn in ihrem Verlauf an die Kontur der zuvor festgelegten Leiterbahnen angepaßt ist, um durch diese "anschmiegende" Leiterbahnführung eine gute Flächenausnutzung zu erreichen (vergl. Fig.2). Des weiteren sind erforderliche Kontakte an den Leiterbahnen derart in bezug auf die mit ihnen verbundenen Leiterbahnen verschoben angeordnet, daß sie in eine bei der betreffenden benachbarten Leiterbahn enthaltene Einbuchtung hineinverschoben sind, um die Flächenausnutzung weiter zu verbessern.

Ein Basiszellen-Generator kommuniziert mit anderen Generatorprozeduren über eine definierte Schnittstelle. In dem Inhalt dieser Prozedur-Schnittstelle drückt sich die Flexibilität der Basiszelle aus. Zur Realisierung eines konkreten Layout ist diese Schnittstelle mit folgenden Daten zu besetzen:

-Designregeln des aktuellen Herstellungsprozesses.

-Zellenindividualisierung zur Angabe der zelleninternen Verschaltung in einer netzlistenähnlichen Form (vergl. Tabelle 1).

-Zellenspezifische Konstruktionsregeln, z.B. horizontale oder vertikale Lage der Transistorgates.

-Zellenanschlüsse zur Vorgabe der Koordinaten.

-Allgemeine Steuerdaten, die festlegen, ob und in welcher Weise ein Layout oder ein Simulationsmodell erzeugt werden soll.

Über die Basiszellen-Schnittstelle werden als Ergebnis der Generierung ausgegeben:

-Layout, z.B. in HKP-Format.

-Simulationsmodell.

-Realisierte Zellenabmessungen und Anschlußkoordinaten.

Ein wichtiges Kennzeichen des Basiszellen-Generators ist seine Unabhängigkeit von den Entwurfsregeln eines bestimmten Herstellungsprozesses. Die erforderlichen Aufbau-Algorithmen berücksichtigen alle für eine Struktur und ihre Umgebung in Frage kommenden Abstandsregeln und nicht nur solche, die in gegenwärtigen Prozessen kritisch sind. Damit wird ein fehlerfreier Layout-Aufbau (correctness by construction) gewährleistet.

Folgende Parameter sorgen für einen flexiblen Layout-Entwurf:

-Anzahl der Transistoren (zwei oder vier).

-Transistorabmessungen.

-Breitenvorgabe, individuell für jede Leitung.

-Zahl und Lage von horizontal und vertikal durchlaufenden Leitungen ("Durchläufer") ohne zelleninterne Anschlüsse.

-Koordinaten und Verdrahtungsebenen der Zellenanschlüsse.

-Lage der Wanne und damit Lage der p-bzw. n-Transistoren.

-Zellenspiegelung.

Durch die Koordinatenvorgabe der Basiszellen-Anschlüsse können Basiszellen-Komplexe und somit beliebig umfangreiche Schaltungen durch paßgerechtes Aneinanderfügen (Abutment) aufgebaut werden. Eine Einschaltung eines Verdrahtungsprogramms zur Verknüpfung der Basiszellen kann somit entfallen.

Die Berücksichtigung von durch die Basiszelle laufenden Leitungen ohne zelleninternen Anschluß ist eine besonders wichtige Eigenschaft. Solche Durchläufer können jederzeit problemlos eingefügt oder entfernt werden, da das Layout bei jedem Generatoraufruf mit den aktuellen Parametern vollständig neu erzeugt wird. Damit entfallen die in anderen bekannten Konzepten erforderlichen Manipulationen an bestehenden Layout-Daten.

Für die Güte des Layout ist die Flächenausnutzung maßgebend. Aus diesem Grund sind erfindungsgemäß topologische und geometrische Optimierungsschritte vorgesehen.

Automatische Layout-Generierung heißt, daß die Dimensionierung und Anordnung von Schaltungselementen und die damit verbundene Festlegung geometrischer Strukturen aus der Hand des Designers genommen und in ein Programm verlagert wird. Voraussetzung ist eine geeignete Sprache zur Beschreibung geometrischer Strukturen. Vorteilhafterweise wird dazu anstelle einer speziellen Layout-Beschreibungssprache die höhere Programmiersprache Pascal benutzt, die um geometrische Primitive ergänzt ist (embedded layout language). Damit stehen alle Möglichkeiten der Hochsprache für eine erforderliche prozedurale Beschreibung zur Verfügung. Die prozedurale Beschreibung ermöglicht die Parametrisierung des Layout und eine Designregel-Unabhängigkeit.

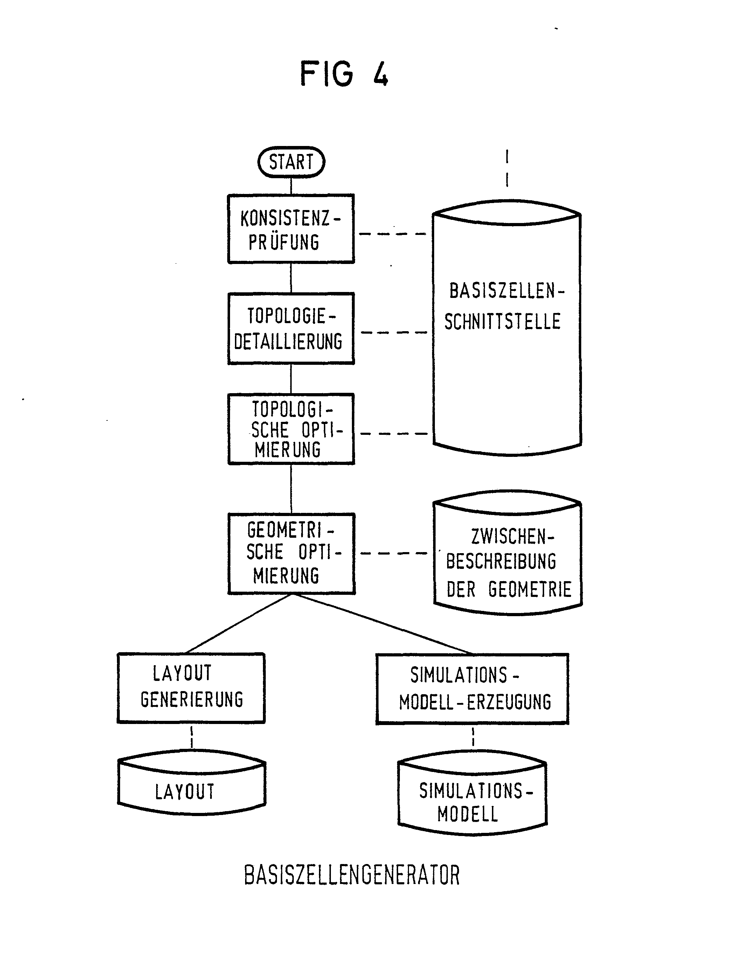

Um Kompaktheit und Güte automatisch generierter Layouts derjenigen von "Handlayouts" anzunähern, wurden die Layout-Strategien von Design-Experten analysiert. Deren Vorgehensweisen wurden herauskristallisiert und algorithmisch formuliert. Dadurch entstanden Prozeduren für die automatische Plazierung von Transistoren, Kontakten und Leiterbahnen. Die verschiedenen Prozeduren eines Basiszellen-Generators (Fig.4) lösen die im folgenden beschriebenen Aufgaben:

-Konsistenzprüfung

Der Inhalt der Schnittstelle wird auf Konsistenz geprüft. Die Prozedur ermittelt u.a., ob alle Transistorelektroden angeschlossen sind und ob Leitungen offene Enden haben.

-Topologie-Detaillierung

Die über die Generator-Schnittstelle vorgegebene Basiszellen-Individualisierung hat die Form einer abstrakten Netzliste. Um ein konkretes Layout zu generieren, muß diese Netzliste in eine detaillierte Schaltungsbeschreibung überführt werden. Daher wurde eine Prozedur implementiert, die die vollständigen Informationen über alle erforderlichen Strukturen generiert, wie z.B. Leiterbahnen als Verbindungselemente zwischen Knoten der Netzliste.

-Topologische Optimierung

Im Anschluß an die Topologie-Detaillierung laufen Prozeduren ab, die die Basiszelle topologisch und geometrisch optimieren. Jede Optimierungsroutine beinhaltet spezielle Expertenfunktionen.

Ein wesentlicher Teil der topologischen Optimierung besteht darin, die optimale Reihenfolge der horizontalen Leiterbahnen zu finden. Darin enthalten ist die Festlegung, welche Bahnen unterhalb bzw. oberhalb der Transistoren angeordnet werden. Zu diesem Zweck sind in dieser Prozedur Entscheidungskriterien abgelegt, die auf dieses Anordnungsproblem angewandt werden. Solche Kriterien sind z.B.:

vertikale Abzweigungen von der horizontalen Bahn in der gleichen Ebene,

Anschlüsse an die Transistorgates,

vertikale Abzweigungen mit Ebenenwechsel,

Vorgaben der Bahnkoordinaten.

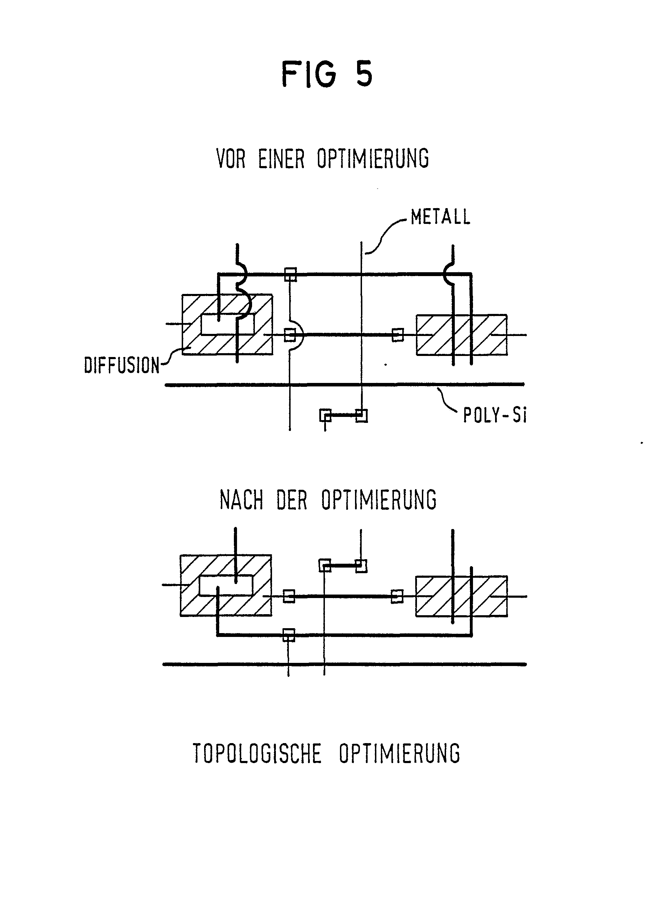

Fig.5 zeigt eine typische Ausgangssituation und das Ergebnis der Optimierung.

Geometrie-Optimierung

Nach der Festlegung der Topologie beginnt die geometrische Optimierung. Hierbei werden zunächst die Koordinaten der vertikalen Leitungen bestimmt. Dabei fließen auch topologische Informationen mit ein, z.B. darüber, ob auf einer vertikalen Leitung ein Kontakt benötigt wird. Nach diesem Schritt folgen die Leitungen so dicht wie möglich aufeinander. In dieses Grundgerüst können die Layout-Elemente (Transistoren, horizontale Poly-Si-Bahnen, Kontakte) "eingehängt" werden.

Um eine kompakte Plazierung der Layout-Elemente zu gewährleisten, wurde ein flexibler horizontaler Zellenrand eingeführt, der den genauen Verlauf der Obergrenze plazierter Strukturen wiedergibt. Dieser Rand ist nach Layout-Ebenen differenziert. Nach jeder neu hinzugefügten Struktur wird der Rand aktualisiert. Eine horizontale Leiterbahn wird beispielsweise so plaziert, daß sie sich dem aktuellen Rand weitestgehend "anschmiegt". Jogs werden automatisch und an der richtigen Stelle erzeugt. Die Jog-Prozedur vermeidet dabei eine unsinnige Leitungsführung mit unnötig tiefen und schmalen Schluchten. Dieses Prinzip der Strukturplazierung wird als "Layering" (Fig.2) bezeichnet.

Bei der Plazierung von Kontakten wird der flexible Rand ebenfalls berücksichtigt. Hinzu kommt eine Ermittlung des horizontalen Verschiebungsspielraumes des Kontaktes. Dieser Spielraum wird ausgenutzt, um den Kontakt gegebenenfalls in eine tiefere Einbuchtung des flexiblen Randes hineinzuverlagern. Darüber hinaus wird ermittelt, ob weitere Kontakte in der Nachbarschaft des zu plazierenden Kontaktes liegen. (Diese Information läßt sich aus dem Schnittstellen-Inhalt entnehmen). Die Plazierungsroutine berechnet die Kontaktlage dann derart, daß alle benachbarten Kontakte in der platzsparendsten Weise angeordnet werden können. Kontakte werden jedoch nicht immer tiefstmöglich plaziert, da auch die Länge der anzuschließenden Leiterbahn in die Betrachtung eingeht.

Die erläuterten Teilverfahren zur geometrischen Layout-Generierung sind jeweils in sich geschlossen, damit eigenständig und können daher auch in anderen Basiszellen-Generatoren eingesetzt werden.

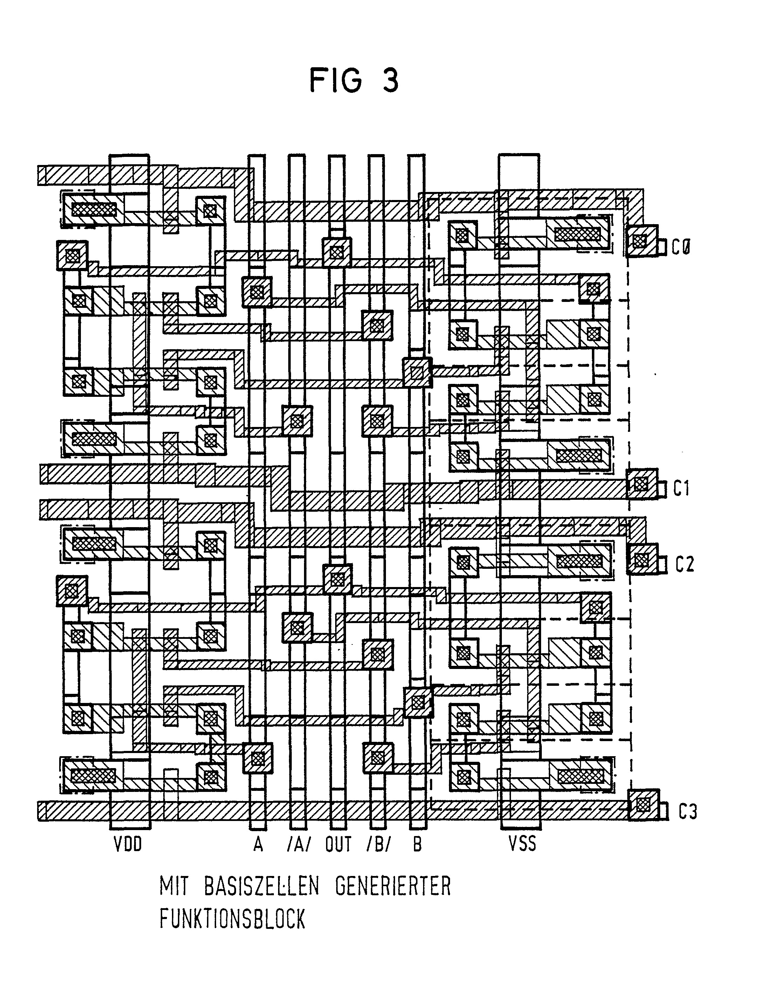

Aus Basiszellen -den Elementen der untersten Hierarchiestufe eines Bausteines -werden vollständige Schaltungsmodule aufgebaut. Fig.3 zeigt als Ausführungsbeispiel eine aus einer Vielzahl der zuvor beschriebenen Basiszelle aufgebaute Teilschaltung, wie sie in einer Bit-Slice-Zelle eines Datenpfades eingesetzt werden kann.

Das erfindungsgemäße Basiszellen-Generierungskonzept reduziert die mit dem Entwurf von VLSI-Layout verbundene Komplexität. Basiszellen - die elementarsten Modulbausteine -erlauben aufgrund der zahlreichen Parametrisierungsmöglichkeiten und der großen Flexibilität eine automatische Zellenanpassung an die jeweilige Layout-Umgebung. Die prozedurale Layout-Beschreibung führt zur Unabhängigkeit des Modulgenerators von den Entwurfsregeln eines bestimmten Herstellprozesses. Algorithmen zur topologischen und geometrischen Optimierung stellen eine effektive Flächenausnutzung sicher. Ein parallel zur Layout-Generierung erzeugter Simulatoranschluß erlaubt eine rasche Verifikation der aus Basiszellen aufgebauten Module.

Die beschriebene Basiszelle ist zwar auf Datenpfade zugeschnitten, jedoch nicht in funktionsspezifischer Weise. Für bestimmte Anwendungen ist allerdings das Erstellen eines für die zu entwerfende Schaltungsfunktion optimierten Basiszellen-Generators sinnvoll (z.B. RAM, ROM). Auch für solche speziellen Basiszellen-Generatoren gelten die Vorteile der hohen Layout-Flexibilität durch prozedurale Beschreibung.

**Ansprüche**

1. In C-MOS-Technik realisierte Basiszelle zum Aufbau von elektronischen Schaltkreisen,

-wobei mehrere Transistoren nebeneinander angeordnet sind,

-wobei parallel zur Erstreckung der Transistoren erste, im wesentlichen aus Polysilizium bestehende Leiterbahnen angeordnet sind,

-wobei senkrecht zu den ersten Leiterbahnen zweite, im wesentlichen aus Metall bestehende Leiterbahnen angeordnet sind, und

-wobei die zweiten Leiterbahnen entweder über die Transistoren oder zwischen den Transistoren verlaufen,

nach Patentanmeldung P 34 22 715.6 DE, dadurch **gekennzeichnet**,

-daß maximal vier Transistoren je Basiszelle vorgesehen sind, wobei jeweils eine Gruppe von Transistoren in n-Kanaltechnik und eine andere Gruppe von Transistoren in p-Kanaltechnik ausgeführt sind, welche Gruppen jeweils einem ersten bzw. einem zweiten Bereich der Basiszelle zugeordnet sind,

-daß die jeweils in einer der Gruppen angeordneten Transistoren zu einer Parallel-oder Serienschaltung zusammengefaßt sind,

-daß in der Basiszelle Metallbahnen außerhalb der Transistorflächen am seitlichen Zellenrand angeordnet sind,

-daß Polysilizium-Leiterbahnen und/oder Metall-Leiterbahnen senkrecht zu den betreffenden Vorzugsrichtungen, nämlich parallel zur Erstreckung der Transistoren bzw. senkrecht dazu, ausgebildet sind,

-daß die Leiterbahnen derart angeordnet sind, daß eine jeweils folgende Leiterbahn in ihrem Verlauf an die Kontur der zuvor festgelegten Leiterbahnen angepaßt ist, um durch diese "anschmiegende" Leiterbahnführung eine gute Flächenausnutzung zu erreichen, und

-daß erforderliche Kontakte an den Leiterbahnen derart in bezug auf die mit ihnen verbundenen Leiterbahnen verschoben angeordnet sind, daß sie in eine bei der betreffenden benachbarten Leiterbahn enthaltene Einbuchtung hineinverschoben sind, um die Flächenausnutzung weiter zu verbessern.

2. Basiszelle nach Anspruch 1, dadurch **gekennzeichnet** , daß die in den Gruppen angeordneten Transistoren paarweise parallel bzw. seriell zusammengeschaltet sind.

3. Basiszelle nach Anspruch 1, dadurch **gekennzeichnet** , daß die in den Gruppen angeordneten Transistoren einzeln ausgebildet sind.

4. Basiszelle nach Anspruch 1, dadurch **gekennzeichnet** , daß die Leiterbahnen mit individuellen, unterschiedlichen Breiten ausgebildet sind.

5. Verfahren zur automatischen Generierung einer Basiszelle nach einem der vorhergehenden Ansprüche, dadurch **gekennzeichnet,**

-daß in einem ersten Schritt eine Beschreibung der angestrebten Basiszelle mittels einer Anzahl von Parametern durchgeführt wird,

-daß in einem zweiten Schritt eine topologische Optimierung der relativen Lagen der Verbindungselemente innerhalb der Basiszelle durchgeführt wird und

-daß in einem dritten Schritt eine geometrische Optimierung der Anordnungen der einzelnen Elemente der Basiszelle durchgeführt wird, um eine optimale Flächenausnutzung zu erzielen.

6. Verfahren nach Anspruch 5, dadurch **gekennzeichnet** , daß zur Erstellung eines für dieses Verfahren geeigneten Programms die Programmiersprache "Pascal" verwendet wird.

# FIG 1

DIFFUSION    METALL    p-WANNE

POLY-Si

BASISZELLE

# FIG 2

"LAYERING" - MECHANISMUS

# FIG 3

MIT BASISZELLEN GENERIERTER
FUNKTIONSBLOCK

# FIG 4

BASISZELLENGENERATOR

# FIG 5

VOR EINER OPTIMIERUNG

NACH DER OPTIMIERUNG

TOPOLOGISCHE OPTIMIERUNG